# EUROPEAN PATENT APPLICATION

(11) **EP 1 379 118 A2**
(43) Date of publication of application: **07.01.2004**
(21) Application number: 03014336.6
(22) Date of filing: 26.06.2003
(51) Int. Cl.: H05K 9/00

(54) **Transparent electromagnetic wave shielding laminate for a display**

(30) Priority: 05.07.2002 JP 2002197657
(71) Applicant: Nisshinbo Industries, Inc., Tokyo (JP)
(72) Inventor: Banno, Koji, Midori-ku, Chiba-shi, Chiba (JP); Kuwabara, Shin, Midori-ku, Chiba-shi, Chiba (JP); Yoshida, Hiroshi, Midori-ku, Chiba-shi, Chiba (JP)
(74) Representative: Leifert & Steffan

(57) **Abstract**

There are disclosed a transparent electromagnetic wave-shielding laminate for display, the laminate comprising an electromagnetic wave-shielding layer (3) wherein at least periphery of a terminal cross section of the layer and / or periphery of an edge thereof is covered with an electroconductive elastomer composition (1) containing an electroconductive filler and a thermoplastic elastomer; a process for producing an electromagnetic wave-shielding laminate comprising bringing an electroconductive elastomer composition into contact with at least periphery of a terminal cross section of an electromagnetic wave-shielding layer and / or periphery of an edge of the layer, and in this state, heat press bonding the composition from a lamination direction and / or cross sectional direction to form an exposed portion on at least peripheral end of the laminate, the portion comprising the composition which is grounded to the layer ; other processes for producing the same; and a display unit (7) comprising the transparent electromagnetic wave-shielding laminate.

The above laminate, which is producible in high production efficiency, is capable of following the unevenness on the electromagnetic wave-shielding laminate and on the display side grounding portion, thereby surely enabling grounding connection and electromagnetic wave-shielding.

## Description

### BACKGROUND OF THE INVENTION

### 1 . Field of the Invention

The present invention relates to a transparent electromagnetic wave-shielding laminate which is excellent in grounding characteristics, a process for producing the laminate and a display unit. More particularly, it pertains to a transparent electromagnetic wave-shielding laminate for display which is capable of surely following the unevenness on the electromagnetic wave-shielding laminate or a display side grounding portion, and attaining not only sure grounding connection but also the prevention of electromagnetic wave leakage; a process for producing the laminate; and a display unit.

### 2 . Description of the Related Arts

It is said that a large amount of electromagnetic wave including non-ionizig radiation such as microwave and electric wave from the surfaces of displays of a variety of computers in office automation (OA) equipment and factory automation equipment and the surfaces of displays of game machines and television sets. In recent years, concern for adverse influences on human health due to the electromagnetic wave has been growing. In addition, obstructions due to the electromagnetic wave to other machinery and equipment become problematic.

Moreover in recent years, attention has been focused upon a plasma display panel (PDP) which is large-sized, of thin wall type and excellent in clarity. It is known that the electromagnetic wave leaking through the front face of a PDP has high intensity as compared with the display units of previous cathode ray tube (CRT), liquid crystal display panel (LCD) and the like, whereby it is strongly required to impart more excellent electromagnetic wave-shielding function to the display units.

In order to prevent the electromagnetic wave from leaking through the display unit as mentioned above, it is generally carried out to install, on the front of display unit, a front sheet (filter) having a high transmittance to visible light (transparency) and electromagnetic wave-shielding function. In recent years, the front sheet has been of a laminate structure laminated with members having not only electromagnetic wave-shielding function but also various functions such as near infrared ray-shielding function, reflection preventing function and antiglare function.

In the meanwhile, it is a problem of practical importance how is the electromagnetic wave-shielding layer is grounded, said layer being in the above-mentioned electromagnetic wave-shielding laminate (front sheet for display) for display. The electromagnetic wave-shielding layer is usually constituted of an electroconductive member. Unless it is properly grounded, there is brought about such a disadvantage that the electromagnetic wave can not escape as electric current, thereby failing to exert the electromagnetic wave-shielding performance.

Such being the case, various devices are made for the grounding of the electromagnetic wave-shielding laminate for display, for instance, a method in which an electroconductive tape is stuck to the periphery of the terminal cross sectional portion of an electromagnetic wave-shielding laminate so as to be in contact with the electromagnetic wave-shielding layer in the laminate and a method in which the size of a layer member arranged on the surface layer of the electromagnetic wave-shielding layer is made a little smaller than that of said layer so as to expose the edge portion of said layer. Grounding connection is carried out by bringing the electroconductive tape or the edge portion of said layer into contact with the display side grounding portion.

However, the method comprising sticking the electroconductive tape needs much labor in sticking the tape to the periphery of the electromagnetic wave-shielding laminate and in particular, cutting and sticking of the tape at corner portions are troublesome. The electroconductive tape is apt to peel off, and since the terminal cross section portion of the electromagnetic wave-shielding layer is not always linearly formed, it is difficult to follow the unevenness on the peripheral portion of the electromagnetic wave-shielding laminate or a display side grounding portion while following the electromagnetic wave-shielding layer, whereby the grounding is prone to become incomplete. This leads to a disadvantage in that unnecessary radiation of electromagnetic wave is prone to leak through the clearance between the electromagnetic wave-shielding laminate and the display side grounding portion. Moreover, the electroconductive tape, which is constituted of woven fabric composed of metal-plated threads or fibrous metal or an electroconductive sheet such as metal foil and an electroconductive tacky adhesive, is not imparted with flexibility or elasticity sufficient to be capable of following the unevenness on an object to be stuck.

With regard to the latter method in which the size of a layer member arranged on the surface layer of the electromagnetic wave-shielding layer is made a little smaller than that of said layer so as to expose the edge portion of said layer, the exposed portion on the electromagnetic wave-shielding layer can not follow the unevenness on the electromagnetic wave-shielding laminate or a display side grounding portion, whereby the grounding is liable to become incomplete. Accordingly, unnecessary radiation of electromagnetic wave is prone to leak through the clearance therebetween as is the case with the method using the electroconductive tape. In addition, the aforesaid method is also disadvantage in that when the electromagnetic wave-shielding laminate undergoes an impact, the electromagnetic wave-shielding layer is prone to chip off at an end thereof.

On the other hand in order to shield the electromagnetic wave which is radiated from electronic machinery and equipment such as personal computers, cellular phones and electrical appliances, investigation is being made on the use of a packing also serving as electromagnetic wave-shielding at the joints of a cage for machinery and equipment. Examples of the electromagnetic wave-shielding packing include an electroconductive elastomer in which an electroconductive medium such as carbon and metallic powder are kneaded and which is processed for molding into the form of packing, and the elastomer which is directly applied to the fitting portions corresponding to joints of a cage therefor by using a dispenser or the like, followed by curing. However, there is not found any example in which an electroconductive elastomer is employed for the PDP having a high leakage intensity of electromagnetic wave for the purpose of grounding between the electromagnetic wave-shielding layer and the main body or for the purpose of protection of electromagnetic wave-shielding layers or display panel surfaces.

In the field of building materials, grounding is carried out by the use of an electroconductive elastomer (composed of an electroconductive filler and an elastomer) on installing portions of electroconductive glass as an electromagnetic wave-shielding window. Therein however, electroconductive sealing material is filled in the clearance between the glass and sash, and there is not found any example in which electromagnetic wave-shielding side (electroconductive glass side) is covered in advance with a thermoplastic elastomer.

### SUMMARY OF THE INVENTION

In the light of such circumstances, an object of the present invention is to provide an electromagnetic wave-shielding laminate for display which is high in production efficiency and capable of surely following the unevenness on the electromagnetic wave-shielding laminate or a display side grounding portion, assuring grounding connection and electromagnetic wave-shielding and at the same time, protecting the electromagnetic wave-shielding laminate and display unit from impact.
Other objects of the present invention will be obvious from the text of this specification hereinafter disclosed.

As a result of intensive research and investigation accumulated by the present inventors in order to achieve the above-mentioned objects, it has been found that sure reliable electromagnetic wave-shielding as well as grounding connection are made possible through an electroconductive elastomer composition by covering an electromagnetic wave-shielding layer with the aforesaid composition containing a thermoplastic elastomer having favorable flowability and an electroconductive filler. The present invention has been accomplished on the basis of the above-mentioned findings and information.

It has also been found by the present inventors that the use of the above-mentioned electroconductive elastomer composition enables a transparent electromagnetic wave-shielding laminate to be produced in high production efficiency and further, the use thereof is extremely industrially advantageous including the case where the electromagnetic wave-shielding laminate is directly stuck onto a display screen.

Specifically, the present invention provides a transparent electromagnetic wave-shielding laminate for display, said laminate comprising an electromagnetic wave-shielding layer wherein at least periphery of a terminal cross section of said layer and / or edge periphery of said layer is covered with an electroconductive elastomer composition containing an electroconductive filler and a thermoplastic elastomer.

Further, the present invention provides:
1 . a process for producing a transparent electromagnetic wave-shielding laminate for display, said process comprising bringing an electroconductive elastomer composition containing an electroconductive filler and a thermoplastic elastomer into contact with at least periphery of a terminal cross section of an electromagnetic wave-shielding layer and / or edge periphery of said layer, and in said state, heat-press bonding said electroconductive elastomer composition from a lamination direction and / or cross sectional direction to form an exposed portion on at least peripheral end of said laminate, said portion comprising said composition which is grounded to the electromagnetic wave-shielding layer;

2 . a process for producing a transparent electromagnetic wave-shielding laminate for display, said process comprising applying an molten or dissolved electroconductive elastomer composition containing an electroconductive filler and a thermoplastic elastomer to at least periphery of a terminal cross section of an electromagnetic wave-shielding layer and / or edge periphery of said layer, and cooling or drying said composition to form an exposed portion on at least peripheral end of said laminate, said portion comprising said composition which is grounded to the electromagnetic wave-shielding layer;

3 . a process for producing a transparent electromagnetic wave-shielding laminate for display, said process comprising arranging an electroconductive elastomer composition containing an electroconductive filler and a thermoplastic elastomer on at least edge periphery of a transparent substrate of said laminate, laminating an electromagnetic wave-shielding layer so that said layer comes into contact with said composition, further laminating members of each of other layers, thereafter heat-press bonding said laminated members thereof from the lamination direction or both the lamination / cross sectional directions to form an exposed portion on at least peripheral end of said laminate, said portion comprising said composition which is grounded to the electromagnetic wave-shielding layer.

Furthermore, the present invention provides:
a display unit comprising a display side grounding portion to be grounded and connected via an exposed portion which comprises an electroconductive elastomer composition containing an electroconductive filler and a thermoplastic elastomer and which is installed on the transparent electromagnetic wave-shielding laminate according to the present invention described above; and
a display unit comprising the transparent electromagnetic wave-shielding laminate according to the present invention described above.

### BRIEF DESCRIPTION OF THE DRAWINGS

FIG. 1 is cross sectional views showing various layer constitutions of the transparent electromagnetic wave-shielding laminate for display according to the present invention;
FIG. 2 shows an example of constitution of a display unit incorporated with the transparent electromagnetic wave-shielding laminate for display according to the present invention;
FIG. 3 shows an example of constitution of a display unit incorporated with the transparent electromagnetic wave-shielding laminate for display according to the present invention; and
FIG. 4 shows an example of constitution of a display unit incorporated with the transparent electromagnetic wave-shielding laminate for display according to the present invention.

### {Designation of Symbols}

1: electroconductive elastomer portion,
2: transparent substrate,
3: electromagnetic wave-shielding layer
4: reflection prevention layer,
5: near infrared ray-shielding layer
6: electromagnetic wave-shielding laminate
7: display body,
8: display side grounding portion,
9: PDP module

### DESCRIPTION OF PREFERRED EMBODIMENT

In the following, detailed description will be given of the present invention.
The transparent electromagnetic wave-shielding laminate for display according to the present invention (hereinafter referred to as 'electromagnetic wave-shielding laminate according to the present invention') is characterized in that at least periphery of a terminal cross section of an electromagnetic wave-shielding layer and / or edge periphery of the layer is covered with an electroconductive elastomer composition containing an electroconductive filler and a thermoplastic elastomer.

By the term 'terminal cross section' of an electromagnetic wave-shielding layer as used herein is meant a cross sectional portion of the electromagnetic wave-shielding layer when the electromagnetic wave-shielding laminate is viewed from a horizontal direction. The terminal cross section, when mentioned as such, may include any of the cases where said layer outwardly protrudes from other layers, where said layer inwardly retreats, and where said layer along with other layer almost align on a same plane.

By the term 'edge' of an electromagnetic wave-shielding layer as used herein is meant an edge portion of said layer which outwardly protrudes from other layers when the electromagnetic wave-shielding laminate is viewed from above or beneath, namely the topside and / or underside of the edge portion of said protruding layer is termed 'edge'.

By the term 'periphery' as used herein is meant not only one side of the terminal cross section of an electromagnetic wave-shielding layer and the edge thereof but also all the sides (all circumferences) thereof. Thus the expression 'periphery is covered with an electroconductive elastomer composition' means that all the sides are covered with an electroconductive elastomer composition.
However, the electromagnetic wave-shielding effect is generally exhibited by the combination of the electromagnetic wave-shielding laminate and the display body and accordingly even if there partially exists such a portion as being non-covered with the electroconductive elastomer composition such as four corners of the laminate depending upon the shape of the display side grounding portion, the electromagnetic wave-shielding effect can be expected. It is preferable, however, that at least 80%, preferably at least 90% based on 100% of the overall periphery length of the electromagnetic wave-shielding laminate according to the present invention be covered with said composition for the purpose of also simplifying the display side grounding portion.

Next some description will be given of the electroconductive elastomer composition to be used in the present invention.
The thermoplastic elastomer as a constituent of the electroconductive elastomer composition to be used in the present invention is a polymer having rubbery elasticity at around ordinary temperature, and is endowed with such characteristics as being capable of readily following the shape of a contact portion even if the contact portion is not planar including unevenness. Being thermoplastic, said elastomer can readily firmly be bonded adhesively to the electromagnetic wave-shielding layer through heat-press bonding upon the production of the electromagnetic wave-shielding laminate, thus assuring complete effect on grounding and electromagnetic wave-shielding property.
As the thermoplastic elastomer being one of the components constituting the electroconductive elastomer composition to be used in the present invention, there are usable one species or two or more species in combination that are selected from the resins of polyurethane base, polyester base, styrene base, olefin base, polyamide base and the like.

### (1) Polyurethane base thermoplastic elastomer

As the polyurethane base thermoplastic elastomer to be used in the present invention, an elastomer is preferable which has a hard segment composed of a diisocyanate and a short-chain glycol (ethylene glycol, propylene glycol, 1, 4-butanediol, bisphenol A and the like) and a soft segment composed of a diisocyanate and a long-chain polyol. As the long-chain polyol which constitutes the soft segment, there are preferably usable a polyether base polyol such as poly(alkylene oxide) glycol having a molecular weight of 400 to 6,000 and polyester base polyol such as polyalkylene adipate, polycaprolactone and polycarbonate. As the diisocyanate compound, there are preferably usable well known customary compounds such as phenylene diisocyanate; tolylene diisocyanate; xylylene diisocyanate; 4, 4'-diphenylmethane diisocyanate and hexamethylene diisocyanate. Preferable polyurethane base thermoplastic elastomers available on the market are exemplified by, for instance, Mobilon (trade name, manufactured by Nisshinbo Industries Inc.), Elastolan (trade name, manufactured by Takeda Badische Urethane Co. Ltd.), Miractolan (trade name, manufactured by Miractolan Co. Ltd.), Rezamin P (trade name, manufactured by Dainichiseika Color & Chemicals Mfg. Co. Ltd.) and U-fine P (trade name, manufactured by Asahi Glass Co. Ltd.).

### (2) Polyester base thermoplastic elastomer

Examples of the polyester base thermoplastic elastomers to be used in the present invention include polyester / polyether block copolymer in which use is made of an aromatic polyester as a hard segment and an aliphatic polyether as a soft segment; polyester /polyester block copolymer in which use is made of an aromatic polyester as a hard segment and an aliphatic polyester as a soft segment; and liquid crystal type elastomers in which use is made of liquid crystal molecules as a hard segment and an aliphatic polyester as a soft segment. The polyester / polyether block copolymers available on the market are exemplified by, for instance, Pelplene P (trade name, manufactured by Toyobo Co. Ltd), Hightrel (trade name, manufactured by Toray Du Pont Co. Ltd.), Lowmod (trade name, manufactured by Japan G.E. Plastics Co. Ltd.), Nichigoh Polyester (trade name, manufactured by Nippon Synthetic Chemical Industry Co. Ltd.), Teijin Polyester Elastomer (trade name, manufactured by Teijin Ltd.). The polyester /polyester block copolymers available on the market are exemplified by Pelplene S (trade name, manufactured by Toyobo Co. Ltd).

### (3) Styrene base thermoplastic elastomer

Examples of the styrene base thermoplastic elastomers to be used in the present invention preferably include styrene / butadiene /styrene block copolymer, styrene / isoprene / styrene block copolymer, styrene / ethylene · butylene / styrene copolymer, styrene /ethylene · propylene copolymer, hydrogenated products thereof, hydrogenated polymer of random SBR, and an elastomer containing as a base, a hydrogenated product of styrene / conjugated diene block copolymer selected from a mixture of the above-exemplified copolymer. Preferable styrene base thermoplastic elastomers available on the market are exemplified by, for instance, Krayton G (trade name, manufactured by Shell Japan Co. Ltd), Septon and Highbler (trade name, manufactured by Kuraray Co. Ltd), Toughtec (trade name, manufactured by Asahi Chemical Industry Co. Ltd) and Dainalon (trade name, manufactured by JSR). The styrene base thermoplastic elastomers containing as a base, a hydrogenated product of styrene /conjugated diene block copolymer are exemplified by, for instance, Rubberon (trade name, manufactured by Mitsubishi Chemical Industry Co. Ltd), Krayton G compound (trade name, manufactured by Shell Japan Co. Ltd), Septon compound (trade name, manufactured by Kuraray Co. Ltd) and Toughtec compound E series (trade name, manufactured by Asahi Chemical Industry Co. Ltd).

### (4) Olefin base thermoplastic elastomer

Examples of preferable olefin base thermoplastic elastomers to be used in the present invention include an elastic body of amorphous random copolymer comprising an olefin as a principal component such as olefin base copolymer rubber exemplified by ethylene · propylene copolymer rubber (EPM), ethylene · propylene · non-conjugated diene copolymer rubber (EPDM) and elastomers comprising as a base, an elastic body which has been crosslinked by heat treatment in the presence of an organic peroxide or the like.
The olefin base copolymer rubber may be any of random copolymer, block copolymer, graft copolymer and alternating copolymer, and it may be used alone or in combination with at least one other. The olefin base thermoplastic elastomers which comprise olefin base copolymer rubber as a principal component and which are available on the market are exemplified by, for instance, Thermolan (trade name, manufactured by Mitsubishi Chemical Industry Co. Ltd), Mirastomer (trade name, manufactured by Mitsui Chemical Industry Co. Ltd), Sumitomo TPE (trade name, manufactured by Sumitomo Chemical Co. Ltd.) and Santoplane (trade name, manufactured by Advanced Elastomer Systems Co. Ltd.).

### (5) Polyamide base thermoplastic elastomer

Examples of preferable polyamide base thermoplastic elastomers to be used in the present invention include those in which use is made of polyamide (nylon 6, 66, 610, 11, 12 and the like) as a hard segment and polyester or polyether as a soft segment. As polyether or polyester, long chain polyol of polyether diol or polyester diol is preferably used. Examples of the polyether diol include poly(oxytetramethylene) glycol and poly(oxypropylene) glycol. Examples of the polyester diol include poly(ethylene adipate) glycol, poly(butylene - 1, 4 -adipate) glycol. Preferable polyamide base thermoplastic elastomer available on the market are exemplified by, for instance, Pebacks (trade name, manufactured by Toray industries, Inc.), Daiamide - PAE (trade name, manufactured by Dicel- Huels Ltd.), Ube Polyamide Elastomer (trade name, manufactured by Ube Industries Ltd.) Nobamit PAE (trade name, manufactured by Mitsubishi Chemical Industry Co. Ltd), Glilax A (trade name, manufactured by Dainippon Ink and Chemicals, Inc.) and Glilon ELX, ELY (trade name, manufactured by Emusu Japan Co. Ltd).

It is preferable that the thermoplastic elastomers to be used in the present invention have each a melt flow rate (MFR) as measured in accordance with JIS K 7210 "Testing method for flow of thermoplastic plastics" being 2 gram per 10 minutes in the temperature range of 80 to 200°C. The MFR, when being within the range, enables the elastomers to be firmly bonded adhesively to the electromagnetic wave-shielding layer through heat-press bonding, and assure complete effect on grounding and electromagnetic wave-shielding property. The test load at the time of MFR measurement is in the range of preferably 3 to 50 N, more preferably 3 to 20 N, particularly preferably 3 to 10 N.
The MFR per 10 minutes at 80°C, when exceeding 2 gram, unfavorably brings about a problem about heat resistance, thereby causing a fear that the thermoplastic elastomers are cast at the time of heat-press bonding or use, thus leaching out onto the screen. The MFR per 10 minutes at 200 °C , when being less than 2 gram, unfavorably leads to excessively high temperature and pressure at the time of heat-press bonding, thus causing a fear of deteriorating and destroying the electromagnetic wave-shielding laminate.

The electroconductive filler being a constituent for the electroconductive elastomer composition to be used in the present invention is not specifically limited provided that it is dispersible in the above-mentioned elastomer and is capable of imparting electroconductivity to the elastomer. Examples thereof include electroconductive metals and electroconductive carbon. The electroconductive metals are exemplified by gold, silver, copper, aluminum, nickel, palladium, iron, stainless steel, iron oxide (ferrite), tin oxide, indium oxide, lead oxide, silicon carbide, zirconium carbide, titanium carbide, etc. each in the form of powder; metallic fiber such as brass fiber, Al fiber, Cu fiber, stainless steel fiber; metal flake, etc. Any of these has a volume specific resistance of approximately 10⁻⁶ {Ω · cm}. The electroconductive carbon, which is distinguished from carbon black to be used as a filler or a reinforcing agent, signifies such carbon black as having an oil absorption in terms of DBP (dibutyl phthalate) absorption of at least 90 milliliter (mL) / 100 g, preferably at least 100 mL / 100 g, more preferably at least 150 to 400 mL / 100 g. Such electroconductive carbon available on the market is exemplified by # 3050 B, # 3150 B, #3750 B and #3950 B (manufactured by Mitsubishi Chemical Industry Co. Ltd.), Ketchen Black EC, DJ - 600 (manufactured by AKZO Japan Ltd.), # 4500 and # 5500 (manufactured by Tokai Carbon Co.,Ltd.) and acetylene black (manufactured by Denki Kagaku Kogyo K. K.). There are also usable as electroconductive carbon, fibrous carbon such as carbon fiber, carbon milled fiber and carbon nanotube. The electroconductive filler may be used alone or in combination with at least one other. Among the above-cited electroconductive filler, powdery copper and carbon black are particularly preferable. Moreover, powdery ferrite may be used as an electroconductive filler for the purpose of enhancing electromagnetic wave-shielding characteristics.

The electroconductive filler to be used in the present invention, when being in the form of powder, usually has a particle size in the range of preferably 1 nm to 100 micrometer(µm), particularly preferably 10 nm to 10 µm. The particle size, when being smaller than 1 nm, brings about difficulty in dispersing in the thermoplastic elastomer, whereas the size, when being larger than 100 µm, unfavorably leads to deterioration in physical properties and adhesiveness of the electroconductive elastomer.
The electroconductive filler, when being in the form of fiber, has a minor axis size in the range of usually 10 nm to 30 µm, preferably 0.1 to 10 µm, a major axis size in the range of 1 to 100 µm, preferably 10 to 50 µm. The ratio of major axis size to minor axis size (aspect ratio) is in the range of usually 10 to 1000, preferably 100 to 500.

The electroconductive elastomer composition to be used in the present invention may contain at need a component other than an electroconductive filler and a thermoplastic elastomer, such as a crosslinking agent, plasticizer, solvent, antioxidant, etc.

The electroconductive elastomer composition to be used in the present invention can be produced by kneading the above-exemplified components by means of a conventional kneading machine such as a single-screw extruder, twin-screw extruder, multi-screw extruder, Banbury mixer, roll, Brabender and kneader. Usually, each of the components is kneaded and compounded into the form of pellet by the use of an extruder or the like and thereafter, the resultant pellet is processed into the form meeting the demand for practical use (for instance, in the form of tape, sheet or the like). Conversely, it is also possible to directly supply a molding machine with each of the components and to knead the resultant composition to mold the same into a desirable form.
In regard to the blending ratio of the electroconductive filler to the thermoplastic elastomer, 200 to 1200 parts by weight, preferably 300 to 800 parts by weight of the filler is blended with 100 parts by weight of the elastomer. Preferable blending ratio thereof varies depending upon the combination of the filler and the elastomer, and it is preferable to select each component so that the volume specific resistance of the electroconductive elastomer composition is made to be at most 100 Ω · cm, preferably at most 10 Ω · cm, more preferably at most 1 Ω · cm.

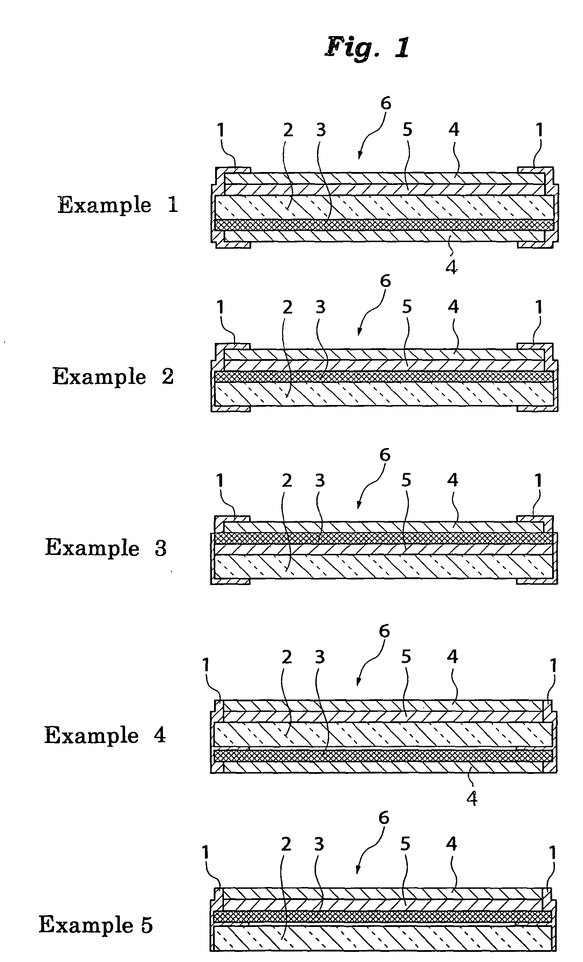

The electromagnetic wave-shielding laminate according to the present invention may have any of layer constitutions, and the member of each of the layers may be produced from any of raw materials, provided that the transparency and the function are not impaired. A fundamental layer constitution of the electromagnetic wave-shielding laminate is exemplified by such constitution as illustrated on FIG. 1 that has a transparent substrate 2, an electromagnetic wave-shielding layer (electroconductive layer) 3, a near infrared ray absorption layer 5 and a reflection prevention layer 4.

As a transparent substrate, there is usually used glass or a synthetic resin each in the form of film, sheet or plate. The substrate has a thickness in the range of usually 50 µm to 10 mm.

Since the electromagnetic wave-shielding laminate according to the present invention is a filter for a display, the electromagnetic wave-shielding layer is a layer which is constituted of an electroconductive material having transparency, and is imparted with an electromagnetic wave-shielding function. The electroconductive material is exemplified by a transparent electroconductive film formed by sputtering or the like, an electroconductive metallic mesh and the like that have heretofore been used without specific limitation. The thickness of the electromagnetic wave-shielding layer is in the range of generally 0.5 to 50 µm excluding the transparent substrate.

Since the electromagnetic wave-shielding laminate according to the present invention is a filter for a display, the near infrared ray absorption layer may be constituted of any known material, provided that the layer is imparted with the function of transmitting visible rays to some extent and absorbing near infrared rays. The thickness of the near infrared ray absorption layer is in the range of generally 0.2 to 20 µm excluding the transparent substrate.

The reflection prevention layer, which is installed to enhance the clarity of display, may be constituted of any previously known material, provided that the layer is imparted with a reflection prevention function. The thickness of the reflection prevention layer is in the range of generally 0.2 to 20 µm excluding the transparent substrate.

In the electromagnetic wave-shielding laminate according to the present invention, at least periphery of the terminal cross section of the electromagnetic wave-shielding layer and / or periphery of the edge of the layer must be covered with an electroconductive elastomer composition. It is necessary that all the periphery of the electromagnetic wave-shielding layer be surely in contact with a portion composed of the electroconductive elastomer composition (hereinafter referred to as "electroconductive elastomer portion"). The electroconductive elastomer portion needs only to function as an exposed electrode for the electromagnetic wave-shielding layer. The layer and electroconductive elastomer portion need only to be in such a contact state as necessary for allowing unnecessary electricity to escape from the layer to the display side grounding portion via the electroconductive elastomer portion.

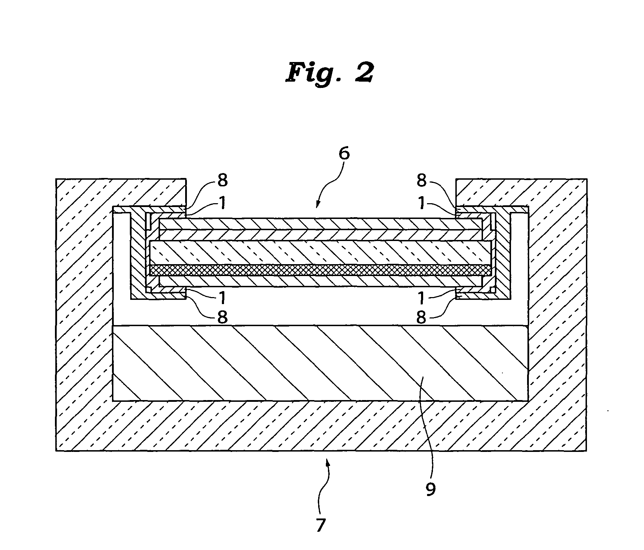

In order that the electroconductive elastomer portion of the electromagnetic wave-shielding laminate according to the present invention may be surely in contact with the display side grounding portion, it is necessary that as illustrated on FIG. 1, the electroconductive elastomer portion 1 be exposed to the outside of the electromagnetic wave-shielding laminate 6. Thus as illustrated on FIG. 2, the laminate 6 is maintained in a state that the electroconductive elastomer portion 1 and the display side grounding portion 8 (electrode portion on a display cage side) of a display body 7 are capable of conducting.

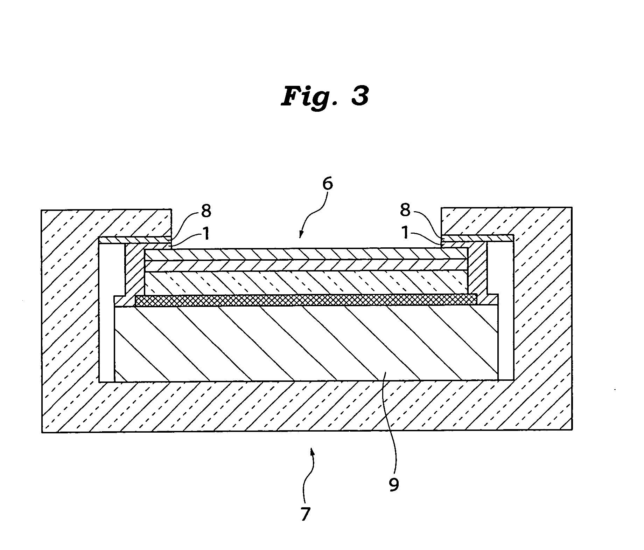

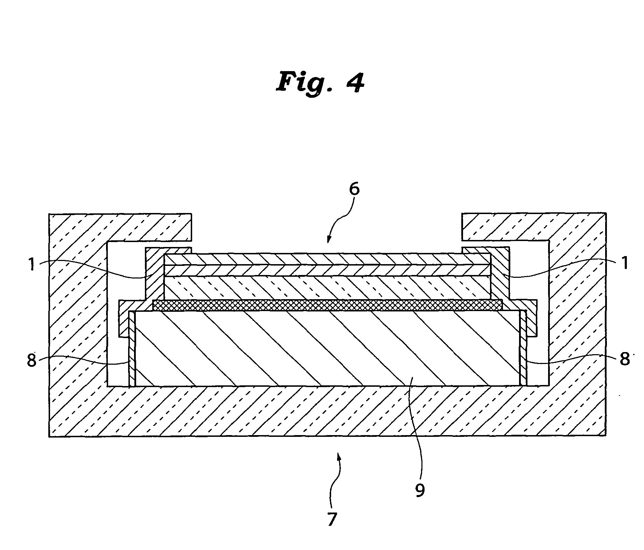

The electromagnetic wave-shielding laminate according to the present invention can be directly stuck to the display screen, and in this case as illustrated on FIG. 3 and 4, the laminate 6 is fixed to the PDP module 9, the electroconductive elastomer portion 1 being in contact with the laminate 6 is also in contact with at least the periphery of the edge of the PDP module 9. In the case shown on FIG. 4, since the display side grounding portion 8 is installed on the periphery of flanks of the PDP module 9, it is required to constitute the portion 1 so as to be in contact not only with the edge of the module 9 but also with the grounding portion 8. Thus the laminate 6 is maintained in a state that the portion 1 and the grounding portion (electrode portion on a display cage side) 8 of a display body 7 are capable of conducting.

The electromagnetic wave-shielding layer laminate 6 according to the present invention is grounded by being brought into contact with the display side grounding portion 8 via the electroconductive elastomer portion 1. The portion 1 is imparted with sufficient flexibility (elasticity) which is capable of surely following the unevenness on the grounding portion 8, thus enabling to realize grounding without fail. In addition, the flexibility imparted to the portion 1 can prevent a clearance from being formed on the contact portion between the laminate 6 and the display and prevent electromagnetic wave leakage through a clearance. The portion 1 is imparted also with elasticity, and exerts a function of protecting the end of the laminate 6 when it undergoes impact.

In the following, some description will be given of processes for producing the electromagnetic wave-shielding laminate according to the present invention (hereinafter referred to as "production process of the invention").
The first production process of the present invention is characterized by a process for producing a transparent electromagnetic wave-shielding laminate for display, said process comprising bringing an electroconductive elastomer composition containing an electroconductive filler and a thermoplastic elastomer into contact with at least periphery of a terminal cross section of an electromagnetic wave-shielding layer and / or periphery of an edge of the layer, and in said state, heat-press bonding said electroconductive elastomer composition from a lamination direction and / or cross sectional direction to form an exposed portion on at least peripheral end of the laminate, said portion comprising said composition which is grounded to the electromagnetic wave-shielding layer.

The first production process of the invention and the second production process to be described hereunder are characterized in that an exposed portion comprising the electroconductive elastomer composition is installed to the electromagnetic wave-shielding layer laminate which has been formed in advance. Therefore, the above-mentioned laminate itself prior to installing the exposed portion may be produced by any of well known processes.

By the term "the peripheral end" of the laminate as mentioned herein is meant the periphery of the terminal cross section of the electromagnetic wave-shielding laminate, excluding the edge of the laminate (refer to Examples 4 and 5 in FIG. 1). When the laminate is viewed from a lamination direction, the exposed portion comprising the electroconductive elastomer composition is in a state of being viewed exposedly to the outside of the end of the laminate. The exposed portion comprising said composition needs only to be in contact at least with the electromagnetic wave-shielding layer, and need not be in contact with terminal cross sections of all the layers constituting the laminate.

By the term "at least peripheral end" of the laminate is meant that at least the peripheral end is included, and the edges of topside and / or underside of the laminate may be covered with the exposed portion (refer to Examples 1 through 3 in FIG. 1).

According to the production process of the invention, by heat-press bonding the electroconductive elastomer composition from a lamination direction and / or cross sectional direction in a state that the electroconductive elastomer composition is brought into contact with the periphery of a terminal cross section of the electromagnetic wave-shielding layer and / or the periphery of a edge of the layer, said composition is surely brought into contact with at least all around the periphery end of said layer. Thereby a clearance which leaks electromagnetic wave is never formed between the layer and the exposed portion comprising the composition.

By the term "heat-press bonding" is meant to apply pressure onto the electroconductive elastomer composition from the directions of lamination and / or cross section to allow the composition to adhere at least to the electromagnetic wave-shielding layer and fix the same, while heat-melting the composition.
Heat-press bonding methods are not specifically limited, but are exemplified by the use of a heat press, heating roll and the like. The heating temperature on heat-press bonding is in the range of usually 80 to 200°C, preferably 100 to 160 °C, and the pressure is in the range of usually 0.1 to 10 MPa, preferably 0.5 to 2 MPa.

The electroconductive elastomer composition may be applied under melting, but the use of the same formed into a tape or sheet under heating pressing across the terminal cross section of the electromagnetic wave-shielding laminate is advantageous in finishing into a uniform condition among the product and at the same time, is preferable in the production process.

The portion comprising the electroconductive elastomer formed in the above-mentioned manner is subjectd to grounding connection by being brought into contact with the periphery of electromagnetic wave-shielding layer on the one hand, and on the other hand, with the display side grounding portion at the portion exposed at the peripheral end of the electromagnetic wave-shielding laminate. The exposed portion comprising the electroconductive elastomer composition is imparted with flexibility necessary for surely following the unevenness on the display side grounding portion, thus enabling to prevent the formation of an clearance between the exposed portion and the display side grounding portion. Thereby it is possible to prevent harmful electromagnetic wave emitted through the front of the display from leaking outside.

The second production process of the present invention is characterized by a process for producing a transparent electromagnetic wave-shielding laminate for display, said process comprising applying coating of an molten or dissolved electroconductive elastomer composition containing an electroconductive filler and a thermoplastic elastomer to at least periphery of a terminal cross section of an electromagnetic wave-shielding layer and / or periphery of an edge of said layer, and cooling or drying said composition to form an exposed portion on at least peripheral end of said laminate, said portion comprising said composition which is grounded to the electromagnetic wave-shielding layer.

In the second production process of the present invention, the exposed portion is formed by coating the periphery of a terminal cross section of an electromagnetic wave-shielding layer and / or periphery of an edge of the layer with the electroconductive elastomer composition made into the form of paste by melting or dissolving with a solvent in advance, and cooling or drying said composition. The second production process is different from the first production process in that the former dispenses with heat-press bonding.

In the case of melting the electroconductive elastomer composition, the melting temperature of the composition is in the range of usually 80 to 200°C , preferably 100 to 160 °C .
Examples of solvent to be used for dissolving the electroconductive elastomer composition include, for instance, hydrocarbons such as toluene, xylene, benzene, hexane and cyclohexane; ethers such as Cellosolve (trade name), carbitol, tetrahydrofuran (THF) and dioxolane; ketones such as acetone, methyl ethyl ketone, methyl isobutyl ketone and cyclohexanone; and esters such as methyl acetate, ethyl acetate, n-butyl acetate and amyl acetate. Any of the above-cited solvents may be used alone or in combination with at least one other.
The molten or dissolved electroconductive elastomer composition has viscosity in the range of 5 to 5000 Pa · s, preferably 50 to 1000 Pa · s. The viscosity, when being unreasonably high, gives rise to the possibility of insufficient contact between the electroconductive elastomer composition and the electromagnetic wave-shielding layer, whereas the viscosity, when being unreasonably low, causes a disadvantage of indefinite shape of the composition.

The third production process of the present invention is characterized by a process for producing a transparent electromagnetic wave-shielding laminate for display, said process comprising arranging an electroconductive elastomer composition containing an electroconductive filler and a thermoplastic elastomer on at least the periphery of an edge of a transparent substrate, laminating an electromagnetic wave-shielding layer so that the layer comes into contact with said composition, further laminating members of each of other layers, thereafter heat-press bonding the laminated members thereof from the lamination direction or both the lamination / cross sectional directions to form an exposed portion on at least peripheral end of said laminate, said portion comprising said composition which is grounded to the electromagnetic wave-shielding layer.

In the first / second production processes, the exposed portion comprising the electroconductive elastomer composition is installed after the fabrication of the electromagnetic wave-shielding laminate is completed. As opposed to the foregoing, in the third production process the composition is incorporated in the stage of laminating each of the layers which constitute the laminate, and the exposed portion comprising the composition is formed simultaneously with the stage of finally finishing this laminate (each of the layers is stuck to one another by heat-press bonding in the direction of lamination).

In the third production process as well, the electroconductive elastomer composition may be applied under melting. Preferably however, the composition formed into a tape or sheet is used by sticking.

In the third production process, in order to bring the electromagnetic wave-shielding layer and electroconductive elastomer composition into contact with each other, the transparent substrate and the layer must be adjacent without fail via the composition. The layer may be placed on the display body side on the basis of the transparent substrate (for instance, refer to Example 4 in FIG. 1) or on the audience side on the basis thereof (for instance, refer to Example 5 in FIG. 1).

In the third production process, as illustrated on Examples 4 and 5 in FIG. 1, there is formed a space due to the thickness of the electroconductive elastomer composition between the transparent substrate and electromagnetic wave-shielding layer. It is preferable therefore, according to the demand, to laminate each of the layers by sandwiching a transparent hot-melt adhesive film or the like between the layers, put the resultant laminate in a bag which is made of a resin such as polypropylene and which is subjected to mold releasing treatment, evacuate the bag and thereafter heat press the same from outside. By this procedure, it is made possible to prevent the dislocation of the transparent substrate and the members of each layer thus laminated. Further by the evacuation treatment, it is made possible to exhaust the air present among the members of each layer, to minimize the air remaining among the members of each layer of the laminate after the pressing and also to enhance the adhesivity. The heat pressing is carried out through a batchwise system by placing the laminated members of each layer which have been housed in the resin bag between hot plates capable of heating, and applying pressure under heating.

Next some description will be given of the display unit having a display side grounding portion according to the present invention which unit is intended for escaping unnecessay electricity coming from the electromagnetic wave-shielding laminate to the display side.
The display unit according to the present invention is characterized by comprising a display side grounding portion to be grounded and connected via the exposed portion which comprises an electroconductive elastomer composition containing an electroconductive filler and a thermoplastic elastomer and which is installed on the transparent electromagnetic wave-shielding laminate according to the present invention described above.

By the term "display side grounding portion (display cage side grounding portion)" as used herein is meant the portion which is installed on the display body, and which is intended to accept unnecessay electricity accumulated in the electromagnetic wave-shielding laminate and to let the same escape to the ground or the like. The display side grounding portion is not specifically limited in its shape, but may be of any shape, provided that it is capable of conductibly connecting to the exposed portion comprising the electroconductive elastomer composition of electromagnetic wave-shielding laminate without forming a clearance between the portion and the exposed portion so as to prevent electromagnetic wave leakage. Specific examples thereof are illustrated on FIG. 2 through 4.

Further the present invention provides a display unit comprising the transparent electromagnetic wave-shielding laminate as described hereinbefore. The display unit is exemplified by those as illustrated on FIG. 2 through 4 wherein the display body 7 is incorporated with the electromagnetic wave-shielding laminate according to the present invention via the display side grounding portion 8. Aside from the unit as illustrated on FIG. 2, another units are exemplified by those illustrated on FIG. 3 and 4 having such configuration wherein a display screen (PDP module 9 in the figure) and the electromagnetic wave-shielding laminate according to the present invention are directly bonded adhesively to each other, not only the periphery end of the laminate but also at least the edge of the display screen are covered with the electroconductive elastomer composition, and the exposed portion comprising the electroconductive elastomer composition is brought into contact with the display side grounding portion which is installed at the position shown on FIG. 3 and 4.
The display unit of such constitution as illustrated on FIG. 2 through 4 according to the present invention can surely let unnecessary electricity escape to the display body via the display side grounding portion and at the same time, prevent electromagnetic wave leakage.

In summarizing the working effect of the present invention, it is made possible by the production process to form in an industrially advantageous manner, the exposed portion which comprises the electroconductive elastomer composition and is connected to the electromagnetic wave-shielding layer in the electromagnetic wave-shielding laminate.

Further according to the present invention, grounding and electromagnetic wave-shielding can be realized without fail, since the electroconductive elastomer composition which is imparted with flexibility can follow the unevenness on the electromagnetic wave-shielding laminate and on the display side grounding portion.
In addition, the electromagnetic wave-shielding laminate, the ends of which are covered with the elastic electroconductive elastomer composition, can protect the display unit as well as itself from impact and further can prevent worker's from being injured by cut due to the end of the laminate.

In the following, the present invention will be described in more detail with reference to comparative examples and working examples, which however shall never limit the present invention thereto.

### Preparation Example 1 (Preparation of electroconductive elastomer composition)

The materials at blending proportions as described hereunder were melt kneaded by the use of a twin-screw extruder to obtain pellets comprising a electroconductive elastomer composition. The resultant pellets were melt kneaded by the use of a twin-screw extruder to obtain electroconductive elastomer tape having 0.7 mm thickness and 20 mm width.

### {Materials and blending proportions}

Ether base polyurethane elastomer (manufactured by Nisshinbo Industries Inc. under the trade name "Mobilon P24")···100 parts by weight
Atomized powdery copper passing through 330 mesh (manufactured by Mitsui Mining and Smelting Co., Ltd. under the trade "MA-CD")··· 400 parts by weight
Mn - Zn ferrite (manufactured by Toda Kogyo Corporation under the trade name "BSF - 574")··· 50 parts by weight

### Example 1

### (A) Preparation of electromagnetic wave-shielding laminate having the exposed portion comprising the electroconductive elastomer composition (Example 1 in FIG. 1)

In accordance with the layer constitution as illustrated on Example 1 in FIG. 1, the members of each of the layers were laminated in the order of, viewed from the PDP module side, reflection prevention layer (4), electromagnetic wave-shielding layer (3), transparent substrate (2), near infrared ray-shielding layer (5) and reflection prevention layer (4) to obtain the electromagnetic wave-shielding laminate. During the lamination, the reflection prevention layer (4) to be located on the outside of the PDP module side for the electromagnetic wave-shielding layer, the reflection prevention layer (4) to be located on the outside of the audience side for the electromagnetic wave-shielding layer and the near infrared ray-shielding layer (5) were each prepared and laminated in such dimensions that both length and width thereof were made to be 20 mm smaller than those of other members so that the edges of each side of the electromagnetic wave-shielding layer (3) were exposed by 10 mm.

The members of each of the layers used herein are as follows:
Transparent substrate (2): HS Rex glass with double strength, measuring 3 mm thickness by 1000 mm by 600 mm, manufactured by Central Glass Co.,Ltd.
Electromagnetic wave-shielding layer (3); electroconductive fiber mesh PU-4X- 13530 with mesh size of 135 by 135, fiber diameter of 32 µm, manufactured by Seiren Co.,Ltd.
Reflection prevention layer (4): Tackified AR film consisting of AR film and acrylate base pressure sensitive tacky adhesive layer(25 µm thickness); available on the market, manufactured by Japan Oil and Fats Co., Ltd. under the trade name "Real Tack 8201 UV".

The near infrared ray-shielding layer (5) was prepared by coating a PET film A 4300 having 100 µm thickness (manufactured by Toyobo Co., Ltd.) as the base film with the dispersion product which was prepared by dispersing near infrared ray-absorbing pigments composed of IRG-022 (manufactured by Japan Kayaku Co., Ltd.), NKX-1199 (manufactured by Hayashibara Biochemical Laboratories Inc.) and MIR-101 (manufactured by Midori Kagaku Co., Ltd.) and a color correction pigment composed of Kaya-sorb violet AR and Kaya-sorb blue N (both manufactured by Japan Kayaku Co., Ltd.) in polycarbonate resin L-1250 Z (manufactured by Teijin Chemicals Ltd.) as a near infrared ray-absorbing layer. Further an acrylate base pressure sensitive tacky adhesive layer (25 µm thickness) was placed on the near infrared ray-absorbing layer of the film.
For adhesive bonding of the layers without the acrylate base pressure sensitive tacky adhesive, use was made of an EVA base thermally adhesive film "Elfan OH-501" having 100 µm thickness and melting point of 83°C (manufactured by Japan Matai Co., Ltd.).

Next, the electromagnetic wave-shielding laminate (6) (Example 1 in FIG. 1) was obtained in which even the periphery end of the electromagnetic wave-shielding laminate as well as the periphery of the edge of the reflection prevention layers (4) located on the PDP module side and audience side, respectively were covered with the electroconductive elastomer portion (1) by heat-press bonding the electroconductive elastomer tape to the electromagnetic wave-shielding layer (3) at 160°C and 0.5 MPa by the use of a heat sealer in the directions of the cross section and lamination so that the tape was positioned along the periphery of the electromagnetic wave-shielding laminate.

### (B) Preparation of the display unit equipped with the electromagnetic wave-shielding laminate as prepared above (FIG. 2).

The resultant electromagnetic wave-shielding laminate having the exposed portion comprising the electroconductive elastomer composition was installed to the display unit having the display side grounding portion (8) as illustrated on FIG. 2. Therein the electromagnetic wave-shielding laminate (6) was arranged on the front of the display cage body (7), and was brought into contact with the display side grounding portion (8) installed on the display cage body (7) via the electroconductive elastomer portion (1).

### Example 2

### (A) Preparation of electromagnetic wave-shielding laminate (Example 2 in FIG. 1)

In accordance with the layer constitution as illustrated on Example 2 in FIG. 1, the members of each of the layers were laminated in the order of, viewed from the PDP module (9) side, transparent substrate (2), electromagnetic wave-shielding layer (3), near infrared ray-shielding layer (5) and reflection prevention layer (4) to obtain the electromagnetic wave-shielding laminate. During the lamination, the reflection prevention layer (4) to be located on the outside of the audience side for the electromagnetic wave-shielding layer, and the near infrared ray-shielding layer (5) were each prepared and laminated in such dimensions that both length and width thereof were made to be 10 mm smaller than those of other members so that the edges of each side of the electromagnetic wave-shielding layer (3) were exposed by 10 mm.
The members used herein of each of the layers were the same as those used in Example 1 except for the transparent substrate (2), in which use was made of a PET film A 4300 having 100 µm thickness (manufactured by Toyobo Co., Ltd.).

(B) Integral preparation of the electromagnetic wave-shielding laminate having the exposed portion comprising the electroconductive elastomer composition and the display unit (FIG. 4).
The resultant electromagnetic wave-shielding laminate was laminated onto the screen of the PDP module (9) by using an acrylate base pressure sensitive tacky adhesive. Subsequently the electroconductive elastomer pellets that were obtained in the Preparation Example 1 were extruded into the form of band, while melting the same at 180°C to cover the peripheral end of the laminate, the peripheral edge of the reflection prevention layer (4) of the audience side, the peripheral edge of the PDP module (9) and part of the display side grounding portion (8) as illustrated on FIG. 4. By cooling the extrudate, there was obtained the electromagnetic wave-shielding laminate (6) covered with the electroconductive elastomer portion (1) and integrated with the PDP module (9).

As illustrated on FIG. 4, the electromagnetic wave-shielding laminate (6) is arranged on the front of the PDP module (9), and is brought into contact with the display side grounding portion (8) positioned on the flank side portion of the PDP module (9) via the electroconductive elastomer portion (1).

### Example 3

### (A) Preparation of electromagnetic wave-shielding laminate having the exposed portion comprising the electroconductive elastomer composition. (Example 4 in FIG. 1)

By arranging the electroconductive elastomer tape as obtained in the Preparation Example 1 on the peripheral edge of the transparent substrate (2), there was obtained the transparent substrate (2) the peripheral edge of which was covered with the electroconductive elastomer tape by 5 to 7 mm from the end of the edge. Subsequently, in accordance with the layer constitution as illustrated on Example 4 in FIG. 1, the members of each of the layers were laminated in the order of, viewed from the PDP module (9) side, reflection prevention layer (4), electromagnetic wave-shielding layer (3), the above-prepared transparent substrate (2), near infrared rays-shielding layer (5) and reflection prevention layer (4) to obtain a laminate. The resultant laminate was placed in a bag which had been made of polypropylene and the inside of which had been subjected to mold releasing treatment, was evacuated, and thereafter was heat-press bonded in the lamination direction by using a heat press at a temperature starting from 120°C to stepwise raised 150°C . After cooling, the laminate was taken out from the bag. As a result, there was obtained the electromagnetic wave-shielding laminate only the peripheral end of which was covered with the electroconductive elastomer portion (1).
The members of each of the layers used herein were the same as those used in Example 1.

### (B) Preparation of the display unit equipped with the electromagnetic wave-shielding laminate as prepared above (refer to FIG. 2).

The resultant electromagnetic wave-shielding laminate having the exposed portion comprising the electroconductive elastomer composition was installed to the display unit having the display side grounding portion (8) as illustrated on FIG. 2. Therein the electromagnetic wave-shielding laminate (6) was arranged on the front of the display cage body (7), and was brought into contact with the display side grounding portion (8) installed on the display cage body (7), via the electroconductive elastomer portion (1).

### Comparative Example 1

### (A) Preparation of electromagnetic wave-shielding laminate having the exposed portion comprising an electroconductive tape.

Instead of heat-press bonding the electroconductive elastomer tape obtained in Preparation Example 1 onto the periphery of the terminal cross section of the electromagnetic wave-shielding laminate having the layer constitution same as that in Example 1, a metallic fabric-made electroconductive tape 1825 having 25 mm width (manufactured by Teraoka Seisakusho Co.,Ltd.) was laminated so as to come into contact with the electromagnetic wave-shielding layer to obtain an electromagnetic wave-shielding laminate having an exposed electrode portion comprising the electroconductive tape.

### (B) Preparation of the display unit equipped with the electromagnetic wave-shielding laminate as prepared above (refer to FIG. 2).

Similarly to Example 1, the resultant electromagnetic wave-shielding laminate having the exposed portion comprising the electroconductive tape was installed to the display unit having the display side grounding portion (8) as illustrated on FIG. 2. Therein the electromagnetic wave-shielding laminate (6) was arranged on the front of the display cage body (7), and was brought into contact with the display side grounding portion (8) installed on the display cage body (7), via the electroconductive elastomer portion (1).

### Testing Example 1

Evaluations were made of external appearance such as adhesion conditions and electromagnetic wave-shielding performances of any of the electromagnetic wave-shielding laminates having the exposed electrode portion which were fabricated in any of the examples and comparative examples in accordance with the testing procedures as described hereunder.

### {Evaluations of external appearance such as adhesion condition and the like}

An observation was made of external appearance such as adhesion condition of any of the electromagnetic wave-shielding laminates that were formed after the lamination of the electroconductive elastomer or the electroconductive tape. As the results, with regard to Examples 1 through 3, the exposed portion comprising the electroconductive elastomer portion was uniformly formed on the periphery of the laminate. With regard to Comparative Example 1, there was caused blistering presumably due to unevenness on the peripheral end of the laminate outwardly from the electroconductive tape, and there was observed fouling presumably due to pressure sensitive tacky adhesive of the tape on the display through-vision portion of the laminate.

### {Evaluations of electromagnetic wave-shielding performances}

In accordance with 3m method based on FCC Standard, a measurement was made of the electromagnetic wave attenuation effect in the region of 100 KHz to 1 GHz to evaluate the electromagnetic wave performances. With regard to Examples 1 through 3, the electromagnetic wave which leaked from the display unit incorporated with the electromagnetic wave-shielding laminate was at most 35 dB in the above-mentioned region, and the performance thereof was judged as being favorable. As opposed thereto with regard to Comparative Example 1, it was confirmed that peak leakage of electromagnetic wave from the display unit incorporated with the laminate exceeded 40 dB at around 68 MHz.

## Claims

1. A transparent electromagnetic wave-shielding laminate for display, said laminate comprising an electromagnetic wave-shielding layer wherein at least periphery of a terminal cross section of said layer and / or periphery of an edge of said layer is covered with an electroconductive elastomer composition containing an electroconductive filler and a thermoplastic elastomer.

2. The electromagnetic wave-shielding laminate according to Claim 1 wherein the thermoplastic elastomer is at least one species selected from the group consisting of styrenic, olefinic and polyamidic resins.

3. The electromagnetic wave-shielding laminate according to Claim 1 wherein the thermoplastic elastomer has a melt flow rate (MFR) of 2 grams per 10 minutes at a temperature in the range of 80 to 200°C .

4. The electromagnetic wave-shielding laminate according to Claim 1 wherein the electroconductive filler is selected from the group consisting of metallic powders, metallic fibers, metal oxide powders, metal oxide fibers, electroconductive carbon powders and electroconductive carbon fibers.

5. The electromagnetic wave-shielding laminate according to Claim 1 wherein the electroconductive filler is ferrite powder.

6. The electromagnetic wave-shielding laminate according to Claim 1 wherein the electroconductive elastomer composition has a volume specific resistance of at most 100 Ω · cm.

7. The electromagnetic wave-shielding laminate according to Claim 1 wherein at least periphery of terminal cross sections of all the layers which constitute the electromagnetic wave-shielding laminate containing the electromagnetic wave-shielding layer is covered with the electroconductive elastomer composition.

8. The electromagnetic wave-shielding laminate according to Claim 1 wherein periphery of terminal cross sections of all the layers which constitute the electromagnetic wave-shielding laminate containing the electromagnetic wave-shielding layer, and edges on the display side of said laminate are covered with the electroconductive elastomer composition.

9. A process for producing a transparent electromagnetic wave-shielding laminate for display, said process comprising bringing an electroconductive elastomer composition containing an electroconductive filler and a thermoplastic elastomer into contact with at least periphery of a terminal cross section of an electromagnetic wave-shielding layer and / or periphery of an edge of said layer, and in said state, heat-press bonding said electroconductive elastomer composition from a lamination direction and / or cross sectional direction to form an exposed portion on at least peripheral end of said laminate, said portion comprising said composition which is grounded to the electromagnetic wave-shielding layer.

10. The process for producing an electromagnetic wave-shielding laminate according to Claim 9 wherein use is made of the electroconductive elastomer composition which is molded into the form of a tape or sheet.

11. A process for producing a transparent electromagnetic wave-shielding laminate for display, said process comprising applying coating of an molten or dissolved electroconductive elastomer composition containing an electroconductive filler and a thermoplastic elastomer to at least periphery of a terminal cross section of an electromagnetic wave-shielding layer and / or periphery of an edge of said layer, and cooling or drying said composition to form an exposed portion on at least peripheral end of said laminate, said portion comprising said composition which is grounded to the electromagnetic wave-shielding layer.

12. A process for producing a transparent electromagnetic wave-shielding laminate for display, said process comprising arranging an electroconductive elastomer composition containing an electroconductive filler and a thermoplastic elastomer on at least edge periphery of a transparent substrate of said laminate, laminating an electromagnetic wave-shielding layer so that said layer comes into contact with said composition, further laminating members of each of other layers, thereafter heat-press bonding said laminated members thereof from the lamination direction or both the lamination / cross sectional directions to form an exposed portion on at least peripheral end of said laminate, said portion comprising said composition which is grounded to the electromagnetic wave-shielding layer.

13. The process for producing an electromagnetic wave-shielding laminate according to Claim 12 wherein use is made of the electroconductive elastomer composition which is molded into the form of a tape or sheet.

14. The process for producing an electromagnetic wave-shielding laminate according to Claim 12, comprising placing a laminate of members of each of the layers in a resin made bag the inside of which has been subjected to mold releasing treatment, evacuating the bag inside, thereafter heat pressing, and removing the resin made bag.

15. A display unit comprising a display side grounding portion to be grounded and connected via an exposed portion which comprises an electroconductive elastomer composition containing an electroconductive filler and a thermoplastic elastomer and which is installed on the transparent electromagnetic wave-shielding laminate as set forth in Claim 1.

16. A display unit comprising the transparent electromagnetic wave-shielding laminate as set forth in Claim 1.

17. The display unit according to Claim 16 wherein the electromagnetic wave-shielding laminate is in direct contact with a display screen, and periphery of a terminal cross section of said laminate and at least edge periphery of the display screen are covered with an electroconductive elastomer composition.
